# EUROPÄISCHE PATENTSCHRIFT

(11) **EP 0 615 343 B1**
(45) Veröffentlichungstag und Bekanntmachung des Hinweises auf die Patenterteilung: **09.12.1998**
(21) Anmeldenummer: 94101939.0
(22) Anmeldetag: 09.02.1994
(51) Int. Cl.: H03L 7/107

(54) **Schaltungsanordnung zur Erzeugung einer Abstimmspannung**
Circuit arrangement for generating a tuning voltage
Dispositif de circuit pour générer un signal d'accord

(30) Priorität: 11.03.1993 DE 4307673
(43) Veröffentlichungstag der Anmeldung: 14.09.1994
(73) Patentinhaber: Blaupunkt-Werke GmbH, D-31139 Hildesheim (DE)
(72) Erfinder: Bartels, Stefan, Dr., D-29553 Bienenbüttel (DE); Schwarz, Detlef, D-30451 Hannover (DE)

(56) Entgegenhaltungen:
- US-A- 3 729 688
- US-A- 4 009 450
- US-A- 5 146 187

## Beschreibung

Die Erfindung geht aus von einer Schaltungsanordnung nach der Gattung des Hauptanspruchs.

Aus der US-A-5 146 187 ist ein Schleifenfilter für eine Phasenregelschleife zum Einsatz in einem Suchlaufempfänger beschrieben, dessen Bandbreite von einem weiten Frequenzbereich zur Gewährleistung eines schnellen Einrastens auf eine eventuell im Rahmen des Sendersuchlaufs gefundene Sendefrequenz auf einen schmalen Frequenzbereich für einen möglichst ungestörten Empfang der zuvor ermittelten Sendefrequenz umschaltbar ist. Zur Reduzierung von Einschwingvorgängen infolge der Bandbreitenumschaltung erfolgt diese in zwei Stufen von einem weiten auf einen mittleren und von diesem auf einen schmalen Frequenzbereich. Zur Realisierung der mittleren Bandbreite des Schleifenfilters sind in dieses ein zusätzlicher Widerstand der über einen diesem in Serie geschalteten zusätzlichen Schalter aktivierbar ist, zwischen Ein- und Ausgang des Filters eingesetzt, wobei der Eingangsanschluß der Widerstandes über einen zusätzlichen Kondensator mit einem Bezugspotential verbunden ist.

Die Einschwingzeit von Phasenregelschleifen (PLL-Schaltungen) bei einem Frequenzwechsel ist umgekehrt proportional zur Grenzfrequenz fg der Schleife. Dabei ist fg diejenige Frequenz, bei der die Verstärkung des offenen Kreises 1 bzw. 0 dB beträgt. Je höher die Grenzfrequenz fg ist, desto schneller schwingt eine PL-Schaltung ein.

Im eingeschwungenen Zustand ist jedoch das Verhalten einer PLL-Schaltung mit kleinerer Grenzfrequenz günstiger. Unter anderem ist die Dämpfung einer Referenzfrequenz, welche der Phasenvergleichsschaltung zugeführt wird, um so größer, je geringer die Grenzfrequenz ist. Insbesondere bei PLL-Schaltungen für Rundfunkempfänger, bei denen die Referenzfrequenz wesentlich von der Oszillatorfrequenz abweicht, machen sich Störungen der Abstimmspannung durch die Referenzfrequenz bemerkbar.

Schnelles Einschwingen und geringe Srörungen sind daher gegensätzliche Forderungen, so daß bei üblicherweise angewandten PLL-Schaltungen ein Kompromiß zu finden ist. Besonders groß sind die Forderungen an eine kurze Einschwingzeit bei Empfängern, die für kurze Zeit von der jeweils empfangenen Frequenz probehalber auf eine andere Frequenz umgeschaltet werden. Dieses erfolgt beispielsweise bei Autoradios zur Prüfung darauf, ob Sender mit anderen Frequenzen das gleiche Programm bzw. die für den gleichen geografischen Bereich gültigen Verkehrsdurchsagen bringen, jedoch mit einer höheren Feldstärke zu empfangen sind. Dabei ist das probehalber Umschalten so kurz, daß je nach der Anwendung weiterer Maßnahmen nur möglichst geringe Störungen des Empfangs auftreten.

Bisher bekannte Schaltungsanordnungen zur Umschaltung der Grenzfrequenz arbeiten grundsätzlich mit einer Umschaltung der Schleifenverstärkung, beispielsweise in Form einer Umschaltung von Ausgangsströmen der PLL-Schaltung oder eines Widerstandes im Schleifenfilter. Dabei wird jedoch der Kurvenverlauf, das heißt die Abhängigkeit der Schleifenverstärkung von der Frequenz im Bereich der Grenzfrequenz versteilert, womit eine schlechtere Stabilität der PLL-Schaltung verbunden ist.

Aufgabe der vorliegenden Erfindung ist es, eine Schaltungsanordnung zur Erzeugung einer Abstimmspannung mit einer PLL-Schaltung anzugeben, welche bezüglich ihrer Grenzfrequenz umschaltbar ist, wobei jedoch unabhängig von der jeweiligen Grenzfrequenz ein stabiler Betrieb möglich ist.

Diese Aufgabe wird mit den kennzeichnenden Merkmalen des Hauptanspruchs gelöst.

Eine vorteilhafte Ausführungsform der Erfindung besteht darin, daß mehrere Schleifenfilter mit unterschiedlicher Grenzfrequenz vorgesehen sind, deren Eingänge wahlweise mit einem Phasendetektor verbindbar sind. Bei einer anderen Ausführungsform ist vorgesehen, daß das Schleifenfilter ein aktives Filter ist, dessen frequenzbestimmenden Glieder umschaltbar sind.

Bei der Verwendung mehrerer Schleifenfilter tritt beim Umschalten von einem auf das andere Schleifenfilter ein weiterer Einschwingvorgang der Abstimmspannung auf.

Aufgabe einer weiteren Ausführungsform der Erfindung ist es, eine PLL-Schaltung derart auszuführen, daß sie sowohl schnell einschwingt, beispielsweise bei der Abstimmung auf einen neuen Sender, und im stationären Betrieb auf geringes Rauschen und eine hohe Dämpfung der Referenzfrequenz ausgelegt ist, wobei für den Übergang beider Betriebsarten kein erneutes Einschwingen der Abstimmspannung erforderlich sein soll.

Diese Ausführungsform ist dadurch gekennzeichnet, daß zwischen den Eingängen zweier Schleifenfilter ein Widerstand angeordnet ist und hat den Vorteil, daß über den Widerstand der Kondensator des zweiten Schleifenfilters bereits während der Einschwingphase der von der Phasenvergleichsschaltung abgegebenen Spannung bereits folgt, so daß beim Umschalten eine mindestens tendentiell richtige Spannung am Kondensator des zweiten Schleifenfilters liegt. Insbesondere bei für PLL-Schaltungen ausgelegten integrierten Schaltungen besteht der Aufwand zur Durchführung der Erfindung lediglich aus einem zusätzlichen Widerstand. Diese Ausführungsform kann sowohl zusammen mit den kennzeichnenden Merkmalen des Hauptanspruchs, als auch unabhängig davon angewendet werden.

Durch die in weiteren Unteransprüchen aufgeführten Maßnahmen sind vorteilhafte Weiterbildungen und Verbesserungen der im Hauptanspruch angegebenen Erfindung möglich.

Ausführungsbeispiele der Erfindung sind in der Zeichnung anhand mehrerer Figuren dargestellt und in der nachfolgenden Beschreibung näher erläutert. Es zeigt:
- Fig. 1: ein Blockschaltbild eines ersten Ausführungsbeispiels,
- Fig. 2: ein Blockschaltbild einer bekannten PLL-Schaltung,
- Fig. 3: ein Bodediagramm für die bekannte Schaltungsanordnung nach Fig. 2,
- Fig. 4: eine weitere bekannte Schaltungsanordnung,
- Fig. 5: ein Bodediagramm für die bekannte Schaltungsanordnung nach Fig. 2 unter Verwendung eines Schleifenfilters nach Fig. 4,
- Fig. 6: ein Bodediagramm für die erfindungsgemäße Schaltungsanordnung nach Fig. 1,
- Fig. 7: ein zweites Ausführungsbeispiel einer erfindungsgemäßen Schaltungsanordnung und
- Fig. 8: ein drittes Ausführungsbeispiel.

Gleiche Teile sind in den Figuren mit gleichen Bezugszeichen versehen.

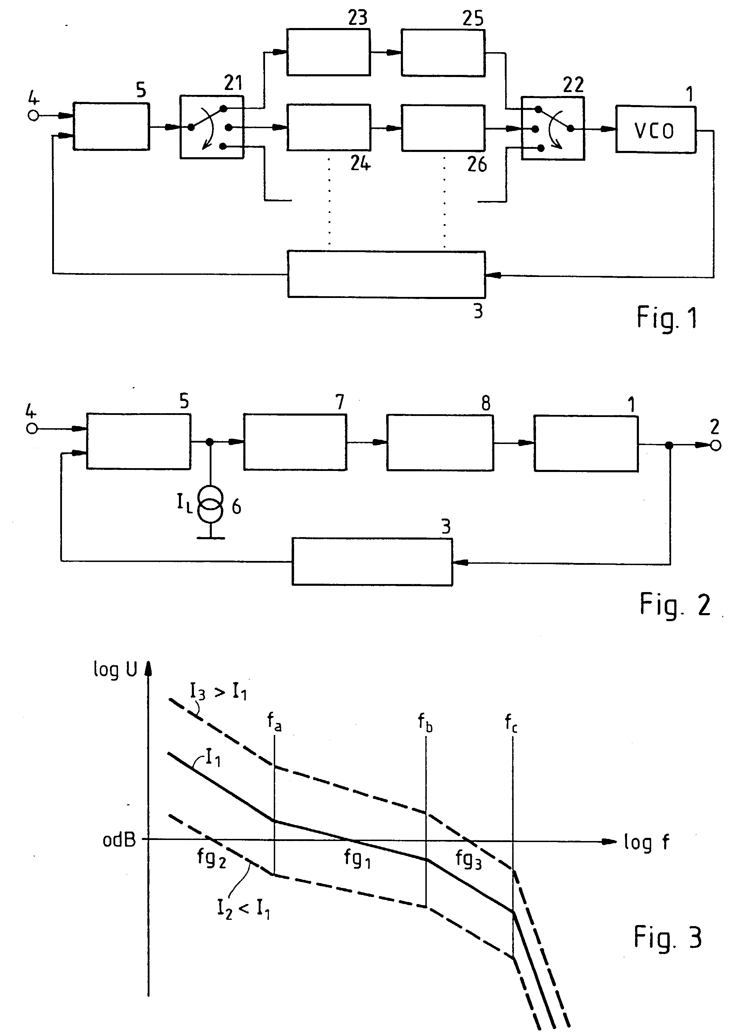

Bei der bekannten Schaltungsanordnung gemäß Fig. 2 ist ein steuerbarer Oszillator 1 von einer Abstimmspannung U steuerbar, während am Ausgang 2 des Oszillators 1 die vom Oszillator erzeugte Wechselspannung einem nicht dargestellten Mischer zuführbar ist. Außerdem gelangt das Ausgangssignal des Oszillators 1 zu einem programmierbaren Frequenzteiler 3, der zur Einstellung der gewünschten Empfangsfrequenz dient. Dessen Ausgangssignal wird zusammen mit einer bei 4 zugeführten Referenzfrequenz einem Phasendetektor 5 zugeleitet.

Der Phasendetektor 5 ist ausgangsseitig als Stromquelle geschaltet. Die Stromquelle 6 symbolisiert die am Eingang des Schleifenfilters 7 auftretenden Leckströme Iₗ, die von den nicht gesondert dargestellten Stromquellen am Ausgang des Phasendetektors 5 kompensiert werden müssen. Da diese Kompensation im allgemeinen mit Stromimpulsen erfolgt, führt ein hoher Leckstrom zu hohen Stromimpulsen im eingeschwungenen Zustand und damit zu Störungen auf der Abstimmspannung des Oszillators 1. Hierdurch wird die erhöhte Störunterdrückung durch Schleifenfilter mit tieferer Grenzfrequenz notwendig.

Der Ausgangsstrom des Phasendetektors 5 wird einem Schleifenfilter 7 zugeführt, das ausgangsseitig über einen Tiefpaß 8 mit dem Steuereingang des Oszillators 1 verbunden ist. Zur Charakterisierung der Eigenschaften derartiger PLL-Schaltungen wird ihr Verhalten bei offener Schleife betrachtet, nämlich die Schleifenverstärkung in Abhängigkeit von der Frequenz, was für die bekannte Schaltungsanordnung gemäß Fig. 2 in Fig. 3 in Form eines Bodediagramms dargestellt ist. Sowohl die Verstärkung als auch die Frequenz sind im logarithmischen Maßstab aufgetragen. Dabei gilt die durchgezogene mittlere Kurve für einen mittleren Schleifenstrom I₁ = Ausgangsstrom des Phasendetektors 5 mit der Grenzfrequenz fg₁. Das Schleifenfilter 7 weist die Eckfrequenz fₐ und f_{b} auf, während die Eckfrequenz des Tiefpasses 8 bei f_{c} liegt.

Soll nun die Grenzfrequenz zur Erzielung einer kürzeren Einschwingzeit erhöht werden, wird bei der Schaltungsanordnung nach Fig. 2 der Strom heraufgesetzt, beispielsweise auf einen Wert I₃. Damit bewegt sich auch die Grenzfrequenz nach oben, gelangt jedoch in einen Zweig der Kurve, der steiler ist. Damit ist ein ungünstigeres Stabilitätsverhalten verbunden. Das gleiche gilt für den Fall eines niedrigeren Stroms I₂ mit der Grenzfrequenz fg₂.

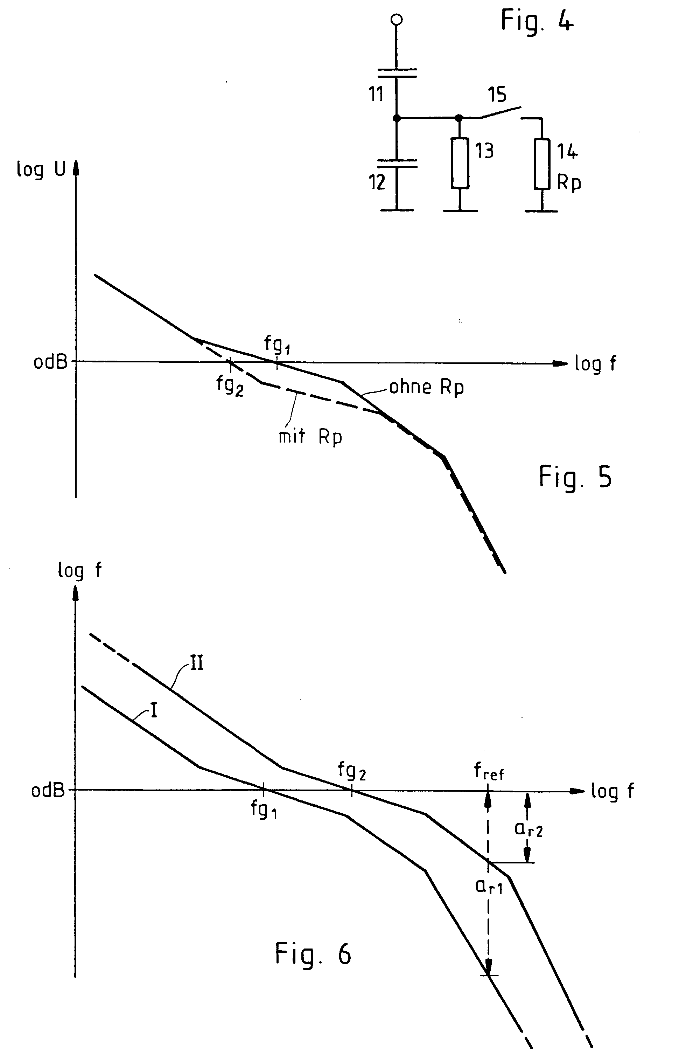

Fig. 4 stellt eine weitere bekannte Möglichkeit zur Änderung der Grenzfrequenz einer PLL-Schaltung dar, die darin besteht, daß für eine höhere Grenzfrequenz einem aus Kondensatoren 11, 12 und einem Widerstand 13 bestehenden Filter ein weiterer Widerstand 14 mit Hilfe eines Schalters 15 parallelgeschaltet wird. Der in Fig. 5 als durchgezogene Linie dargestellte Verstärkungsverlauf des Filters nach Fig. 4 ohne den Widerstand 14 nimmt dann den gestrichelt gezeichneten Verlauf ein, wobei die Steigung im Bereich der Grenzfrequenz fg₂ ebenfalls stärker ist als die Steigung bei fg₁.

Bei der in Fig. 1 dargestellten erfindungsgemäßen Schaltungsanordnung sind am Ausgang des Phasendetektors und am Steuereingang des Oszillators 1 steuerbare Umschalter 21, 22 vorgesehen, die jeweils eine von mehreren Reihenschaltungen aus je einem Schleifenfilter 23, 24 und einem Tiefpaß 25, 26 einschalten. Obwohl in den meisten Anwendungsfällen eine Umschaltung zwischen zwei Schleifenfiltern ausreichend ist, kann im Rahmen der Erfindung auch zwischen mehr als zwei Schleifenfiltern umgeschaltet werden. Die Schleifenfilter sind derart ausgebildet, daß sich zwar die Grenzfrequenz ändert, es jedoch zu keiner absoluten Verstärkungsänderung kommt, was in Fig. 6 dargestellt ist.

Die mit II bezeichnete Kurve gilt für ein Schleifenfilter mit höherer Grenzfrequenz, was ein schnelles Einschwingen ermöglicht. Mit der Kurve I mit der Grenzfrequenz fg₁ wird eine gute Störunterdrückung erzielt, was in Fig. 2 am Beispiel der Referenzfrequenz f_{ref} dargestellt ist, für welche die Kurve II eine geringe Dämpfung von aᵣ₂ aufweist, die bei der Umschaltung der Schleifenfilter auf den Wert aᵣ₁ ansteigt.

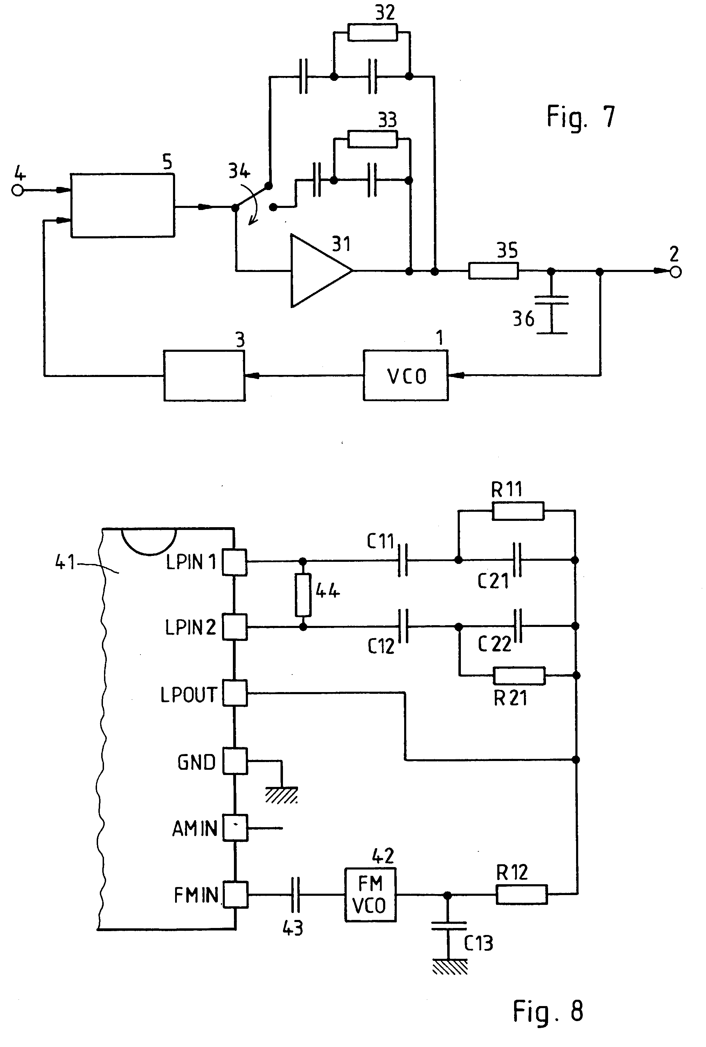

Fig. 7 zeigt ein Ausführungsbeispiel mit einem aktiven Schleifenfilter, das aus einem Verstärker 31 und zwei in je einem Gegenkopplungskreis befindlichen Filtern 32, 33 besteht, von denen jeweils eines mit Hilfe eines Umschalters 34 eingeschaltet werden kann. Für beide mit dem aktiven Schleifenfilter darstellbare Grenzfrequenzen genügt ein einziger Tiefpaß aus einem Widerstand 35 und einem Kondensator 36.

Bei dem Ausführungsbeispiel nach Fig. 8 bezeichnet 41 einen an sich bekannten integrierten Schaltkreis, beispielsweise vom Typ TDA 7326, der außer einem steuerbaren Oszillator 42 und den Schleifenfiltern alle wesentlichen Teile einer PLL-Schaltung enthält, also insbesondere einen programmierbaren Frequenzteiler und eine Phasenvergleichsschaltung. Letzterer hat zwei Ausgänge LPIN1 und LPIN2, von denen jeweils einer je nach Einschwingzustand aktiv ist. Der Ausgang LPIN1 ist über ein erstes Schleifenfilter, das aus den Kondensatoren C11, C21 und dem Widerstand R11 besteht, und über einen Tiefpaß R12, C13 mit einem Steuereingang des Oszillators 42 verbunden. Der Ausgang des Oszillators 42 ist über einen Kondensator 43 an einen Eingang FMIN des integrierten Schaltkreises 41 angeschlossen.

Der zweite Ausgang LPIN2 des integrierten Schaltkreises 1 ist über das zweite Schleifenfilter, das aus den Kondensatoren C12, C22 und einem Widerstand R21 besteht, über den Tiefpaß R12, C13 mit dem Steuereingang des Oszillators 42 verbunden. Erfindungsgemäß werden nun die beiden Ausgänge LPIN1 und LPIN2 über einen Widerstand 44 verbunden. Der Widerstand 44 ist derart groß, daß die Eigenschaften der beiden Schleifenfilter, welche das Verhalten im Einschwingzustand und im stationären Zustand bestimmen, im wesentlichen erhalten bleiben. Er bewirkt jedoch während des Einschwingens, wobei das erste Schleifenfilter C11, C21, R11 verwendet wird, ein allmähliches Aufladen des Kondensators C12 auf die sich während des Einschwingens einstellende Spannung. Sobald diese am Ende des Einschwingvorgangs einen etwa stabilen Wert eingenommen hat, wird von dem integrierten Schaltkreis 41 der Ausgang LPIN2 eingeschaltet und der Ausgang LPIN1 abgeschaltet. Das zweite Schleifenfilter C12, C22, R21 befindet sich bereits in einem Zustand, in dem es ohne weiteren störenden Einschwingvorgang weiter betrieben wird.

## Patentansprüche

1. Schaltungsanordnung zur Erzeugung einer Abstimmspannung für einen Oszillator in einem Rundfunkempfänger mit Hilfe einer Phasenregelschleife, dadurch gekennzeichnet, daß eine Umschaltung des Schleifenfilters (23; 24; 31, 32, 33) derart erfolgt, daß die durch eine Schleifenverstärkung von 1 definierte Grenzfrequenz durch die Umschaltung geändert wird, ohne daß sich die Abhängigkeit der Verstärkung von der Frequenz im Bereich der Grenzfrequenz wesentlich ändert.

2. Schaltungsanordnung nach Anspruch 1, dadurch gekennzeichnet, daß mehrere Schleifenfilter (23; 24) mit unterschiedlicher Grenzfrequenz vorgesehen sind, deren Eingänge wahlweise mit einem Phasendetektor (5) verbindbar sind.

3. Schaltungsanordnung nach Anspruch 2, dadurch gekennzeichnet, daß jeweils ein Schleifenfilter (23; 24) in Reihe mit einem Tiefpaß (25, 26) geschaltet ist und daß die Ausgänge der Tiefpässe (25, 26) wahlweise mit einem Steuereingang des Oszillators (1) verbindbar sind.

4. Schaltungsanordnung nach Anspruch 2, dadurch gekennzeichnet, daß die Schleifenfilter (C11, C21, R11; C12, C22, R21) mit einem gemeinsamen Tiefpaß (R12, C13) verbunden sind.

5. Schaltungsanordnung nach einem der Ansprüche 2 bis 4, dadurch gekennzeichnet, daß zwischen den Eingängen zweier Schleifenfilter(C11, C21, R11; C12, C22, R21) ein Widerstand (44) angeordnet ist.

6. Schaltungsanorndung nach Anspruch 5, dadurch gekennzeichnet, daß der Widerstand (44) derart groß gewählt ist, daß der von ihm und einem anschließenden Kondensator des Schleifenfilters gebildete Tiefpaß eine Grenzfrequenz hat, welche niedriger als die Grenzfrequenz des Schleifenfilters mit der niedrigeren Grenzfrequenz ist.

7. Schaltungsanordnung nach Anspruch 1, dadurch gekennzeichnet, daß das Schleifenfilter (31, 32, 33) ein aktives Filter ist, dessen frequenzbestimmenden Glieder (32; 33) umschaltbar sind.

8. Schaltungsanordnung nach einem der Ansprüche 5 oder 6, dadurch gekennzeichnet, daß in Abhängigkeit vom Einschwingzustand eines der beiden Schleifenfilter (C11, C21, R11; C12, C22, R21) mit Signalen beaufschlagt wird.

## Claims

1. Circuit arrangement for generating a tuning voltage for an oscillator in a broadcast receiver with the aid of a phase locked loop, characterized in that the loop filter (23; 24; 31, 32, 33) is switched in such a manner that the cut-off frequency defined by a loop gain of 1 is changed by the switching without significantly changing the dependence of the gain on the frequency within the range of the cut-off frequency.

2. Circuit arrangement according to Claim 1, characterized in that a number of loop filters (23; 24) having a different cut-off frequency are provided, the inputs of which can be optionally connected to a phase detector (5).

3. Circuit arrangement according to Claim 2, characterized in that in each case one loop filter (23; 24) is connected in series with a low-pass filter (25, 26) and that the outputs of the low-pass filters (25, 26) can be optionally connected to a control input of the oscillator (1).

4. Circuit arrangement according to Claim 2, characterized in that the loop filters (C11, C21, Rll; C12, C22, R21) are connected to a common low-pass filter (R12, C13).

5. Circuit arrangement according to one of Claims 2 to 4, characterized in that a resistor (44) is arranged between the inputs of two loop filters (C11, C21, R11; C12, C22, R21).

6. Circuit arrangement according to Claim 5, characterized in that the resistor (44) is selected to be of such a magnitude that the low-pass filter formed by it and a connected capacitor of the loop filter has a cut-off frequency which is lower than the cut-off frequency of the loop filter having the lower cut-off frequency.

7. Circuit arrangement according to Claim 1, characterized in that the loop filter (31, 32, 33) is an active filter, the frequency-determining sections (32; 33) of which are switchable.

8. Circuit arrangement according to one of Claims 5 and 6, characterized in that signals are applied to one of the two loop filters (C11, C21, R11; C12, C22, R21) in dependence on the state of recovery.

## Revendications

1. Circuit pour générer une tension d'accord (signal d'accord) pour un oscillateur d'un récepteur radiophonique, à l'aide d'une boucle de régulation de phase,
caractérisé en ce qu'
on commute le filtre en boucle (23 ; 24 ; 31, 32, 33) de façon que la fréquence limite définie par une amplification en boucle égale à 1, soit modifiée par la commutation sans modifier fondamentalement la relation entre l'amplification et la fréquence au niveau de la fréquence limite.

2. Circuit selon la revendication 1,
caractérisé en ce que
plusieurs filtres en boucle (23, 24) sont prévus avec des fréquences limites différentes, filtres dont les entrées peuvent être reliées sélectivement à un détecteur de phase (5).

3. Circuit selon la revendication 2,
caractérisé en ce que
chaque fois un filtre en boucle (23, 24) est branché en série avec un filtre passe-bas (25, 26), et les sorties des filtres passe-bas (25, 26) peuvent être reliées sélectivement à une entrée de commande de l'oscillateur (1).

4. Circuit selon la revendication 2,
caractérisé en ce que
les filtres en boucle (C11, C21, R11 ; C12, C22, R21) sont reliés à un filtre passe-bas commun (R12, C13).

5. Circuit selon l'une des revendications 2 à 4,
caractérisé en ce qu'
une résistance (44) est branchée entre les entrées des deux filtres en boucle (C11, C21, R11 ; C12, C22, R21).

6. Circuit selon la revendication 5,
caractérisé en ce que
la valeur de la résistance (44) est choisie pour que le filtre passe-bas formé par cette résistance et un condensateur adjacent du filtre en boucle, possède une fréquence limite inférieure à la fréquence limite du filtre en boucle ayant la fréquence limite plus faible.

7. Circuit selon la revendication 1,
caractérisé en ce que
le filtre en boucle (31, 32, 33) est un filtre actif dont les éléments (31, 32, 33) qui définissent la fréquence, peuvent être commutés.

8. Circuit selon l'une des revendications 5 ou 6,
caractérisé en ce qu'
en fonction de l'état d'oscillation, l'un des deux filtres en boucle (C11, C21, R11 ; C12, C22, R21) reçoit les signaux.
